(19) Europäisches Patentamt
European Patent Office
Office européen des brevets

(11) Publication number: 0 179 921
B1

(12) **EUROPEAN PATENT SPECIFICATION**

(45) Date of publication of patent specification: **08.08.90**

(51) Int. Cl.$^5$: **D 06 P 5/00,** D 06 P 1/52, C 03 C 17/32, C 08 J 7/04

(21) Application number: **85902132.1**

(22) Date of filing: **18.04.85**

(86) International application number: **PCT/JP85/00216**

(87) International publication number: **WO 85/04912 07.11.85 Gazette 85/24**

# (54) BASE MATERIAL HAVING A DYED SURFACE FILM AND DYEING METHOD.

(30) Priority: **18.04.84 JP 76624/84**
**16.11.84 JP 240495/84**

(43) Date of publication of application: **07.05.86 Bulletin 86/19**

(45) Publication of the grant of the patent: **08.08.90 Bulletin 90/32**

(84) Designated Contracting States: **DE FR GB IT**

(56) References cited:
**JP-A-4 941 685**
**JP-A-57 117 689**

(73) Proprietor: **NIPPON KAYAKU KABUSHIKI KAISHA**
**11-2, Fujimi 1-chome Chiyoda-ku**
**Tokyo 102 (JP)**

(72) Inventor: **HASHIMOTO, Matsuo**
**3007-2, Shinmachi Tano-gun**
**Gunma 370-13 (JP)**
Inventor: **KIYOMOTO, Masayuki**
**570, Ohazakohri Sanyocho**
**Asa-gun Yamaguchi 757 (JP)**
Inventor: **KARASAWA, Yoshimitsu**
**903-61, Hongo Fujioka-shi**
**Gunma 375 (JP)**
Inventor: **SAKAMOTO, Kenji**
**459-26, Nishiyokotemachi Takasaki-shi**
**Gunma 370-11 (JP)**
Inventor: **KAKUI, Yasuhiko**
**53-5, Shimokawacho Maebashi-shi**
**Gunma 379-21 (JP)**
Inventor: **HIRASAWA, Yutaka**
**3-8-24, Higashiohmiya Ohmiya-shi**
**Saitama 330 (JP)**

(74) Representative: **Woods, Geoffrey Corlett et al**
**J.A. KEMP & CO. 14 South Square Gray's Inn**
**London WC1R 5EU (GB)**

EP 0 179 921 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The present invention relates to a process for producing a base material such as glass having a membrane dyed by an anionic dyestuff on a surface thereof.

In recent years, coloured base materials prepared by coloring transparent base materials such as glass have been used in various displays. Particularly, such transparent, colored base materials are useful as color-resolving filters, and the demand therefor has been increased by their use in liquid crystal color television sets and in color television cameras.

Hitherto, in this technical field, in a method for dying a membrane, a membrane of a natural high polymeric protein material such as casein or gelatin has mainly been used.

According to this method, an aqueous solution prepared by adding potassium bichromate or ammonium bichromate, as a photo-curing agent, to an aqueous solution of a protein such as casein or gelatin in warm water is spin-coated on one of the surfaces of a glass plate, then the thus coated glass plate is irradiated with activating radiation via a mask to form a latent image of a dyeable layer on the glass plate. After actualizing the dyeable layer by development, the thus actualized dyeable layer is dyed by a dyestuff.

In practising the above method the following defects have been experienced:

Proteins such as casein or gelatin are easily putrefied because they are natural products; their quality varies widely depending on their source resulting in extremely poor reproducibility of colours; the membrane is easily exfoliated from the glass plate when immersed in hot water; the physical properties of the proteins are largely deteriorated under heat and conditions in the dyeing method are accordingly restricted.

A deep colour is difficult to obtain due to the limitation of the temperature which can be used in the dyebath.

Use of potassium bichromate or ammonium bichromate as the photo-curing agent results in environmental pollution problems in the operational steps and in waste-disposal, and also results in the bad influence of chromium remaining in the gelatin of the product.

In order to resolve the abovementioned problems, we have examined synthetic high polymers for use in a dyeing method. At first we tried coating the surface of the base material with a polymer having group(s) which has an affinity for an anionic dyestuff or having quaternary ammonium salt group(s), to dye the polymer membrane on the surface of the base material.

In such a case, since the polymer itself has an affinity for an anionic dyestuff, the polymer is dyeable. However, since the polymer is soluble in water, the dried membrane on the base material exfoliated when immersed in a dye bath for dyeing. Thus, it is not possible to dye the membrane on the surface of the base material nor to obtain a coloured base material.

GB—A—1378997 discloses polymer which may be coated on a substrate and dyed, which comprises each of two recurring units, one of which has the formula:

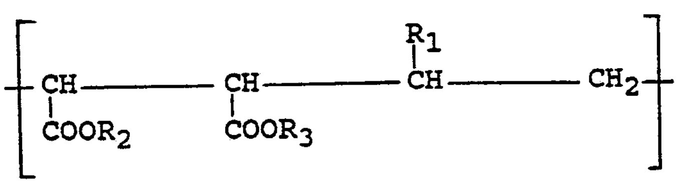

wherein $R_1$ is lower alkyl or phenyl, one of $R_2$ and $R_3$ is hydrogen and the other is —Q—N(lower alkyl)$_2$ wherein Q is the residue of a hydrocarbon having from 1 to 12 carbon atoms from which two hydrogen atoms have been removed, and the other of said recurring units has the formula:

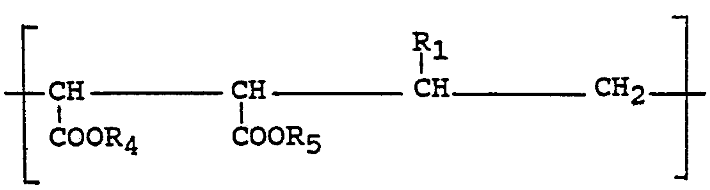

wherein one of $R_4$ and $R_5$ is hydrogen and the other is a group of formula:

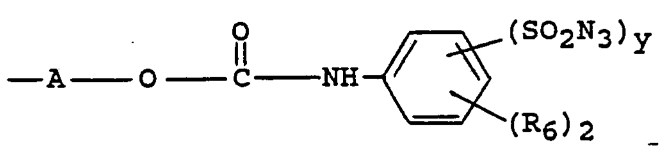

wherein A is alkylene having from 2 to 6 carbon atoms separating the valencies and a total carbon atom content of from 2 to 10, $R_6$ is lower alkyl or halogen, y is 1 or 2, z is 0, 1 or 2, provided that y+z is not greater

than 3, and the $SO_2N_3$ group is in any of positions 3, 4 and 5 in the phenyl nucleus to which it is attached and at least one of the said positions 3, 4 and 5 is unsubstituted, or a salt form of the said polymer.

The present invention provides a process for producing a base material having a dyed membrane on a surface thereof, which process comprises applying a photoreactive resin composition (D) comprising (i) a copolymer (A) of a first vinyl monomer having photosensitive group(s) and a second vinyl monomer copolymerizable therewith and having group(s) having an affinity for an anionic dyestuff, (ii) optionally a photoreaction initiator (B) and (iii) a solvent (C), onto the surface of a base material thereby forming a membrane on the said surface; then irradiating the thus formed membrane with activating radiation to initiate a reaction in the said membrane; and dyeing the thus treated membrane with an anionic dyestuff, characterised in that the said first vinyl monomer is one or more compounds selected from p-cinnamoyloxystyrene, β-cinnamoyloxyethyl vinyl ether, β-cinnamoyloxyethyl acrylate, β-cinnamoyloxyethyl methacrylate, p-(cinnamoyloxymethyl)styrene, p-cinnamoylideneacetoxystyrene, β-(furfurylacryloyloxy)ethyl acrylate, β-(furfurylacryloyloxy)ethyl methacrylate, 7-acryloyloxycoumarine, 7-methacryloyloxycoumarine, 6-hydroxymethylcoumarine acrylate, 6-hydroxymethylcoumarine methacrylate, β-(p-cinnamoylphenoxyethyl)vinyl ether, p-(β-styrylphenyl)acrylate, p-(β-styrylphenyl)methacrylate, p-phenylmaleimidoacetoxystyrene, 4'-methacryloyloxy-4-stilbazole and 1-methyl-4-(p-methacryloyloxystyrylpyridinium) methosulfate; and in that the second vinyl monomer is one or more compounds selected from (N,N-dimethylamino)ethyl acrylate, (N,N-dimethylamino)ethyl methacrylate, (N,N-diethylamino)ethyl acrylate, (N,N-dimethylamino)ethyl methacrylate, (N,N-dimethylamino)propyl acrylate, (N,N-dimethylamino)propyl methacrylate, (N,N-dimethylamino)propyl acrylamide, (N,N-diethylamino)ethyl vinyl ether, 4-vinylpyridine, diallylamine, 2-hydroxy-3-methacryloyloxypropyltrimethylammonium chloride, methacryloyloxyethyltrimethylammonium chloride, methacryloyloxypropyltrimethylammonium chloride, acryloyloxyethyltrimethylammonium chloride and acryloyloxypropyltrimethylammonium chloride.

The present invention further provides a process for producing a base material having a dyed membrane on a surface thereof, which process comprises applying a photoreactive resin composition (D) comprising (i) a copolymer (A) composed of first monomeric units having photosensitive group(s) and second monomeric units having group(s) having affinity for an anionic dyestuff, (ii) optionally a photoreaction initiator (B) and (iii) a solvent (C), onto the surface of a base material thereby forming a membrane on the said surface; then irradiating the thus formed membrane with activating radiation to initiate a reaction in the said membrane; and dyeing the thus treated membrane with an anionic dyestuff, characterised in that:

(1) the said copolymer (A) has been obtained by reacting a homo- or copolymer, obtained by polymerizing a vinyl monomer having tertiary amino group(s), with a compound having both active halogen atom(s) and carbon-carbon unsaturated bond(s),

(2) the said vinyl monomer having tertiary amino group(s) is one or more compounds selected from (N,N-dimethylamino)ethyl acrylate, (N,N-dimethylamino)ethyl methacrylate, (N,N-diethylamino)ethyl acrylate, (N,N-diethylamino)ethyl methacrylate, (N,N-dimethylamino)propyl acrylate, (N,N-dimethylamino)propyl methacrylate, (N,N-dimethylamino)propyl acrylamide, (N,N-diethylamino)ethyl vinyl ether, 4-vinylpyridine and diallylamine, and in that

(3) the said compound having both active halogen atom(s) and carbon-carbon unsaturated bond(s) is one or more compounds selected from allyl chloride, allyl bromide, 3-chloro-2-methylpropene, 3-chloro-1-methylpropene, 4-bromo-1-butene, allyl chloroacetate, vinyl chloroacetate, γ-chloroisobutene, m-chloromethylstyrene, p-chloromethylstyrene, crotyl bromide, 3-chloro-2-hydroxypropyl methacrylate, β-chloroethyl cinnamate, β-bromoethyl cinnamate, β-bromoethyl cinnamylideneacetate, β-bromoethyl furylacrylate, p-β-bromoethyloxycarbonylbenzalacetophenone and 4-chloroacetoxystilbene.

Since copolymer (A) is dyeable with an anionic dyestuff due to the affinity of copolymer (A) for an anionic dyestuff, the membrane on the base material can be easily dyed with an anionic dyestuff. In addition, since copolymer (A)is cross-linkable, it forms a water-insoluble membrane on the surface of the base material, such as glass, when it is irradiated with activating radiation, and accordingly exfoliation of the membrane does not occur when the thus prepared base material is immersed into the dye bath for dyeing.

Furthermore colored base materials of a stable quality are available without fear of putrefaction of the membrane thereon or fear of environmental pollution due to six valent chromium.

The first vinyl monomer may be used singly or as a mixture of two or more of them.

The second vinyl monomer may also be used singly or as a mixture of two or more of them. In addition another monomer which is copolymerizable with any of the above-mentioned monomers, for instance methyl acrylate, methyl methacrylate, ethyl acrylate, ethyl methacrylate or styrene, may be used as a monomer component for preparing copolymer (A).

The relative amounts of the first vinyl monomer or first monomeric units and the second vinyl monomer or second monomeric units depend on the desired strength of the membrane of copolymer (A). When the first vinyl monomer or first monomeric unit content is higher, the strength of the membrane is greater and vice versa. The first vinyl monomer or first monomeric units are preferably present in copolymer (A) in an amount of 0.2 to 30 mol%, particularly 1 to 20 mol%.

In addition, when the content of the second vinyl monomer or second monomeric units is higher, the dyeability of copolymer (A) is excellent. However, in consideration of the effect required from the second

vinyl monomer or second monomeric units, the amount of the second vinyl monomer or second monomeric units is not less than 20 mol%, preferably not less than 40 mol%, in copolymer (A). Copolymer (A) may be prepared by mixing the first vinyl monomer and the second vinyl monomer in a suitable ratio, and, after diluting the monomeric mixture with a solvent if necessary, subjecting the monomeric mixture to copolymerization in the absence of any activating radiation using conventional polymerization techniques.

Copolymer (A) may have both photosensitive group(s) and quaternary ammonium salt group(s) in a same side chain thereof. Such a copolymer may be prepared by various methods, for instance by reacting a homopolymer or a copolymer, obtained by polymerizing a vinyl monomer having tertiary amino group(s), with a compound having both active halogen atom(s) and carbon-carbon unsaturated bond(s).

The vinyl monomer having tertiary amino group(s) may be used singly, or a mixture of two or more of them may be used. If desired another monomer which is copolymerizable with any of them, for instance, methyl acrylate, methyl methacrylate, ethyl acrylate, ethyl methacrylate or styrene, may be used as a component of the monomeric mixture.

The compound having both active halogen atom(s) and carbon-carbon unsaturated bond(s) may be used singly or a mixture of two or more of them may be used.

It is preferred to use 0.2 to 300 mols of the monomer having active halogen atom(s) and carbon-carbon unsaturated bond(s) per 100 mols of the vinyl monomer having tertiary amino group(s). In the thus obtained copolymer (A), it is preferred that the amount of structural monomeric units having both photosensitive group(s) and quaternary ammonium salt group(s) is 0.2 to 30 mol%, particularly 1 to 20 mol%, and that the amount of structural monomeric units which have group(s) having an affinity for an anionic dyestuff is not less than 20 mol%, particularly not less than 40 mol%.

The molecular weight of copolymer (A) is preferably not less than 500.

As the photoreaction initiator (B) which initiates the reaction when the reaction mixture is irradiated with activating radiation, the following compounds may be exemplified:

nitrobenzene, p-nitrodiphenyl, m-nitroaniline, p-nitroaniline, 2,4-dinitroaniline, picramide, 2-chloro-4-nitroaniline, 2,4,6-trinitroaniline, p-nitrophenol, 9-anthraldehyde, acetophenone, benzophenone, dibenzalacetone, benzil, p,p'-dimethylaminobenzophenone, 4,4'-bis(dimethylamino)benzophenone (Michler's ketone), 1,4-naphthoquinone, anthraquinone, 1,2-benzanthraquinone, 2-ethylanthraquinone, 2-t-butylanthraquinone, benzoin, diacetyl, 1,9-benzathrone, 2-keto-3-aza-1,9-benzanthrone, 3-methyl-1,3-diaza-1,9-benzanthrone, 2-nitrofluorene, 2,7-dinitrofluorene, 2,5-dinitrofluorene, 1,8-phthaloylnaphthalene, 2-chloro-1,8-phthaloylnaphthalene, 4-chloro-1,8-phthaloylnaphthalene, 4-bromo-1,8-phthaloylnaphthalene, 5,6-dinitroacenaphthene, 5-benzoylacenaphthene, acenaphthene, pyrene, acridone, α-naphthoquinone, 5-nitroacenaphthene, 1-nitropyrene, chloro-1,2-benzanthraquinone, 9-fluorenone, diphenyl disulfide, p-nitrobenzaldehyde, p-benzoquinone, phenol, anthrone, benzaldehyde, phenanthrene, naphthalene, chrysene, 2-benzoylmethylene-1-methylnaphthothiazoline, N-acetyl-4-nitro-1-naphthylamine, benzoquinone, 4-nitro-1-naphthylamine and anthracene. They may be used singly, or a mixture of two or more of them may be used. It is preferred to use not more than 30 parts by weight, particularly not more than 10 parts by weight, of the initiator (B) per 100 parts by weight of copolymer (A).

As for the solvent (C), a solvent which dissolves both copolymer (A) and the initiator (B) is preferred. Suitable examples are 2-methoxyethanol, 2-ethoxyethanol, toluene, xylene, ethylene glycol monoethyl ether acetate and N-methyl-2-pyrrolidone. They may be used singly, or a mixture of two or more of them may be used. Although the amount of the solvent (C) in the photoreactive resin composition (D) depends on the properties of copolymer (A) and the initiator (B), it is preferred to use the solvent (C) in an amount so as to make the viscosity of the photoreactive resin composition less than 1000 cps (1 Pas), particularly less than 800 cps (0.8 Pas).

Although the photoreactive resin composition (D) comprises copolymer (A), optionally the initiator (B), and the solvent (C), another monomer copolymerizable with copolymer (A) may be added.

As such an additional monomer, a compound having two or more photosensitive groups is preferably used; the following compounds may be exemplified:

ethylene glycol diacrylate, diethylene glycol diacrylate, triethylene glycol diacrylate, polyethylene glycol diacrylate, polyethylene glycol dimethacrylate, polypropylene glycol diacrylate, polypropylene glycol dimethacrylate, butylene glycol diacrylate, butylene glycol dimethacrylate, neopentyl glycol diacrylate, neopentyl glycol dimethacrylate, 1,4-butanediol diacrylate, 1,6-hexanediol diacrylate, 1,6-hexanediol dimethacrylate, pentaerythritol diacrylate, pentaerythritol triacrylate, trimethylolpropane triacrylate, trimethylolpropane trimethacrylate, novolak-epoxyacrylate, bisphenol A-epoxyacrylate, alkylene glycol diepoxyacrylate, glycidyl ester acrylate, polyester-diacrylate, bisphenol-A diacrylate and urethane diacrylate.

By adding the above-mentioned additional monomer to the composition (D), the strength and transparency of the membrane which is formed on the surface of the base material can be further improved.

It is preferred to use the additional monomer in an amount which does not affect the dyeability of the cured membrane on the base material. Thus it is preferred to use not more than 200% by weight, preferably not more than 20% by weight, of the additional monomer relative to the amount of copolymer (A).

The composition (D) may, for example, further contain a viscosity regulating agent or a defoaming agent.

After applying the composition (D) onto the surface of a base material, the solvent in the composition

(D) evaporates to leave a resinous membrane on the said surface. It is possible to prepare a membrane having a thickness of, for example, from 0.5 to 100 μm.

As the base material, glass and a synthetic resin (for instance synthetic acrylic resin) may be exemplified. However, various materials may be used without limitation.

As the activating radiation, visible light, ultraviolet rays, X-rays and electron beams may be exemplified.

The cured resin of the thus formed membrane is dyed with an anionic dyestuff.

As the dyestuff, acid dyes disclosed in "Colour Index", published by the Society of Dyers and Colourists, as C.I. Acid; direct dyes disclosed also in "Colour Index" as C.I. Direct; and reactive dyes disclosed also in Colour Index as C.I. Reactive may be exemplified. The acid dyes are preferred. As the acid dyes for use in the present invention, C.I. Acid Yellow 17, 49, 67, 72, 110, 127, 135, 161; C.I. Acid Red 37, 50, 111, 114, 257, 266, 317; C.I. Acid Blue 41, 83, 90, 113, 129, 182, 125; C.I. Acid Orange 7, 56; C.I. Acid Green 25, 41; C.I. Acid Violet 27, 28, 48 and 97 may be mentioned.

Dyeing is, for example, carried out using an aqueous solution prepared by dissolving 0.01 to 200 parts by weight of a dyestuff in 1000 parts by weight of water. The solution may be weakly alkaline to acidic. Although it is possible to carry out dyeing at from ambient temperature to 100°C, it is preferred to carry out dyeing at a high temperature since only a short dyeing period is required.

After dyeing the dyed material is removed from the dyeing bath and dried to obtain a base material having a dyed membrane on the surface thereof.

The dyed base material is useful, for example, as a colour filter in a liquid crystal colour television set. Since the membrane prepared by curing the photoreactive resin composition has excellent dyeability, it is possible to use a thin membrane. Accordingly, it is possible to apply the dyed base material onto the transparent electrode of a liquid crystal colour television set. In the case of using the dyed base material produced by a process according to the present invention, the picture obtained from the TV set is remarkably bright as compared to that obtained when using a known material.

The invention is now further described in the following Examples.

Example 1

By subjecting a solution prepared by mixing the following reagents,

10 g of 4'-methacryloyloxy-4-stilbazole,

90 g of (N,N-dimethylamino)ethyl methacrylate,

200 g of 2-ethoxyethanol and

1 g of α,α'-azobis(isobutyronitrile)

to polymerization under a nitrogen atmosphere at 60°C for 5 hours in the absence of ultraviolet rays, the whole solution became a viscous liquid. By adding 200 g of 2-ethoxyethanol into the thus obtained viscous liquid, a photoreactive resin composition was prepared.

Separately, a 10% solution in ethanol of a silane-coupling agent KBM503 (made by SHINETSU Chemical Industry Co., Ltd.) was applied on a glass plate, and after air-drying, the thus treated plate was further dried by heating at 110°C for 5 min and after washing the surface thereof with acetone. The washed plate was dried to obtain the base material to be coated with the photoreactive resin composition.

The surface of the thus obtained base material was spin-coated with the photoreactive resin composition so as to form a resin membrane with a thickness of 0.8 μm. Thereafter, the thus coated surface was irradiated with ultraviolet light (80 W/cm) for 1 sec to cure the membrane.

Then, the thus treated base material was subjected to dyeing while using an aqueous 1% solution (pH of 8.0) of a colouring matter for colour filters (made by Nippon Kayaku Co., Ltd. under the name of "Green 1P") at 60°C for 10 min to obtain a glass plate having a transparent membrane dyed deep green thereon.

In the same procedures as above except for respectively using Red 14P and Blue 4P (both being the colouring matters for colour filter, made by Nippon Kayaku Co., Ltd.) instead of Green 1P, glass plates having transparent membranes dyed deep red and blue were obtained.

Examples 2 to 5

Each of the solutions prepared by mixing the reagents shown in the following table was polymerized in the same manner as in Example 1 to obtain a viscous liquid. By dissolving 200 g of 2-ethoxyethanol and, as a photoreaction initiator, 2.5 g of p,p'-tetramethyldiaminobenzophenone (Michler's ketone) in each of the thus prepared viscous liquids, photoreactive resin compositions were prepared.

After applying each of the resin compositions onto a glass plate in the same manner as in Example 1 so as to form a membrane of 0.9 μm thickness, the thus treated glass plate was irradiated with ultraviolet rays to cure the membrane and then subjected to dyeing in the same manner as in Example 1, thereby obtaining glass plates having membranes dyed deep green, red and blue, respectively.

Table

| | Examples | | | |
|---|---|---|---|---|
| | 2 | 3 | 4 | 5 |
| β-cinnamoyloxyethyl acrylate | 15 g | 0 g | 0 g | 10 g |
| p-(β-styrylphenyl) acrylate | 0 | 13 | 0 | 0 |
| p-cinnamylideneacetoxystyrene | 0 | 0 | 12 | 0 |
| (N,N-dimethylamino)ethyl acrylate | 85 | 0 | 78 | 90 |
| (N,N-dimethylamino)ethyl methacrylate | 0 | 87 | 0 | 0 |
| 4-vinylpyridine | 0 | 0 | 10 | 0 |
| α,α'-azobis(isobutyronitrile) | 0.8 | 0.9 | 1.0 | 0.8 |
| 2-ethoxyethanol | 180 | 200 | 190 | 180 |

Reference Example 1

A solution prepared by mixing the reagents set forth below was subjected to polymerization, coating, UV irradiation and dyeing in the same manner as in Example 1.

However, the membrane on the surface of the glass plate exfoliated therefrom, and accordingly, a transparent base plate having a dyed membrane on the surface thereof was not obtained.

100 g of (N,N-dimethylamino)ethyl methacrylate
200 g of 2-ethoxyethanol and
1 g of α,α'-azobis(isobutyronitrile)

For reference, in the following Examples, "part" means part by weight.

Example 6

A solution prepared by mixing the reagents set forth below was subjected to polymerization under a nitrogen atmosphere at 80°C for 8 hours to obtain 100 parts of a solution of poly(N,N-dimethylamino)ethyl methacrylate.

69 parts of toluene
30 parts of (N,N-dimethylamino)ethyl methacrylate
1 part of α,α'-azobis(isobutyronitrile)

After adding 15 parts of a mixture of m-chloromethylstyrene and p-chloromethylstyrene to 50 parts of the thus obtained polymer solution at ambient temperature, the whole mixture was subjected to reaction at ambient temperature and after 16 hours a solid material was obtained.

By dissolving the thus obtained solid material in 260 parts of 2-ethoxyethanol and adding 16 parts of a sensitizer (Irgacure® 651, made by Ciba-Geigy Co.) to the thus prepared solution, a dyeable, photoreactive resin compound was prepared.

Separately, a 10% solution in ethanol of the same silane-coupling agent as in Example 1 (KBM 503, SHINETSU Chem. Ind. Co., Ltd.) was applied onto a glass plate, and, after air-drying, it was further dried at 110°C for 5 min, washed with acetone and further dried to prepare the base material for the photoreactive resin composition.

Then, the photoreactive resin composition was spin-coated onto the surface of the base material so as to form a resin membrane 1 μm thick on the surface of the base material. The thus formed membrane was nonsticky.

Thereafter, the thus coated base material was irradiated with ultraviolet rays (80 W/cm) for 4 sec to cure the membrane thereon.

When the thus prepared base material was immersed in a dye bath containing a 0.04% solution of dye made by dissolving Kayanol Floxine® NK (made by Nippon Kayaku Co., Ltd.) into an aqueous solution of acetic acid of pH 3.3, at 90°C for 20 min, a glass base plate having a transparent membrane dyed bright red was obtained.

Reference Example 2

In the same manner as in Example 6 except for not adding chloromethylstyrene, a resin composition was obtained, and in the same manner as in Example 6, coating, UV irradiation and dyeing was carried out. However, the thus obtained glass base plate had an opaque membrane only dyed to the extent of stains.

Examples 7 and 8 and
Reference Examples 3 and 4

By subjecting glass plates each having a membrane prepared in the same manner as in Example 6 or Reference Example 2 to dyeing, glass plates having a dyed membrane were obtained, the conditions and results of dyeing being shown in Table 1.

Table 1

| | Example 7 | Reference Example 3 | Example 8 | Reference Example 4 |
|---|---|---|---|---|
| Membrane prepared according to | Example 6 | Reference Example 2 | Example 6 | Reference Example 2 |
| Dyestuff | Kayanol Floxine NK® (made by Nippon Kayaku) | | Kayanol Milling Red ® 3BW (made by Nippon Kayaku) | |
| Concentration of the dyestuff | 0.04 % | | 0.03 % | |
| pH of dye bath | 7.9 | | 8.2 | |
| Temperature of dye bath | 90°C | | 90 to 98°C | |
| Time period for dyeing | 20 min | | 5 min | |
| Results | a glass base plate having a membrane dyed deep red was obtained | a glass base plate having a membrane only dyed to the extent of stains was obtained | a glass base plate having a membrane dyed deep red was obtained | a glass base plate having a membrane only dyed to the extent of stains was obtained |

Example 9

Into 50 parts of the toluene solution of poly(N,N-dimethylamino)ethyl methacrylate produced in Example 6, 10 parts of allyl chloride were mixed, and the thus prepared mixture was reacted for 40 hours at room temperature, thereby obtaining a solidified material.

By dissolving the solidified material into 240 parts of 2-ethoxyethanol and adding 24 parts of R—166 (a diacrylate of epoxy compounds made by Nippon Kayaku Co., Ltd.) and 10 parts of Irgacure® 651 (refer to Example 6, a sensitizer) into the thus prepared solution, a photoreactive resin composition was obtained. Then, the thus obtained resin composition was spin-coated onto a glass plate in the same manner as in Example 6 to form a membrane 2 μm thick on the glass plate. The thus formed membrane was nonsticky and its processability was favorable.

The thus treated glass plate was irradiated for 4 sec with ultraviolet rays (80 W/cm) to cure the membrane thereon.

Thereafter, by subjecting the thus irradiated glass plate to dyeing at 90°C for 18 min using an aqueous solution (pH of 8.5) containing 0.05% of Kayarus Turqueise Blue GL® (made by Nippon Kayaku Co., Ltd.), a glass base plate having a transparent membrane dyed deep blue was obtained.

Reference Example 5

Into the solution of poly(N,N-dimethylamino)ethyl methacrylate in toluene of Example 9, 2-ethoxy-ethanol and Irgacure® 651 were added in the same manner as in Example 9, however without adding allyl chloride, to obtain a resin composition. After spin-coating the thus obtained resin composition on a glass plate and irradiating the thus coated glass plate with ultraviolet rays, the glass plate was immersed into a dye bath to dye the resin membrane on the glass plate, in the same manner as in Example 9.

As a result, a glass base plate having a resin membrane was obtained. However, the resin membrane was dyed only to the extent of stains.

Examples 10 and 11 and
Reference Examples 6 and 7

By subjecting glass plates each having a membrane prepared in the same manner as in Example 9 or Reference Example 5 to dyeing, glass base plates having a dyed membrane were obtained, the conditions and results of dyeing being shown in Table 2.

Table 2

| | Example 10 | Reference Example 6 | Example 11 | Reference Example 7 |
|---|---|---|---|---|
| Membrane prepared according to | Example 9 | Reference Example 5 | Example 9 | Reference Example 5 |
| Dyestuff | Kayanol Milling Green 5GW® (made by Nippon Kayaku) | | Kayanol Floxine NK® (made by Nippon Kayaku) | |
| Concentration of dyestuff | 0.045 % | | 0.03 % | |
| pH of dye bath | 3.15 | | 7.9 | |
| Temperature of dye bath | 93°C | | 88°C | |
| Time period for dyeing | 16 min | | 20 min | |
| Results | a glass base plate having a membrane dyed deep green was obtained | a glass base plate having a membrane only dyed to the extent of stains was obtained | a glass base plate having a membrane dyed deep green was obtained | a glass base plate having a membrane only dyed to the extent of stains was obtained |

Examples 12 and 13

Into 45 parts of 2-ethoxyethanol, 5 parts of poly(4-vinylpyridine) of molecular weight 12000 were dissolved, and, after adding 8 parts of a mixture of m-chloromethylstyrene and p-chloromethylstyrene to the thus prepared solution, the mixture was reacted for 20 hours at room temperature.

Then, one part of Irgacure® 651 was dissolved into the reaction product to obtain a photoreactive resin composition.

The thus obtained resin composition was spin-coated onto a glass plate in the same manner as in Example 6 to form a membrane 2 μm thick on the glass plate. The thus formed membrane was non-sticky and its processability was favorable. After irradiating the thus treated glass plate with ultraviolet rays of 80 W/cm for 5 sec, the thus irradiated glass plate was subjected to dyeing under the conditions shown in Table 3.

Reference Examples 8 and 9

Into the same solution of poly(4-vinylpyridine) in 2-ethoxyethanol as in Example 12, one part of Irgacure® 651 was added to obtain a resin composition, and the thus obtained resin composition was spin-coated onto a glass plate. The thus treated glass plate was irradiated with ultraviolet rays and then subjected to dyeing in a similar manner as in Examples 12 and 13. The conditions of dyeing are also shown in Table 3.

Table 3

| | Example 12 | Reference Example 8 | Example 13 | Reference Example 9 |
|---|---|---|---|---|
| Dyestuff | Kayanol Cyanine Green G®1) | | Kayanol Milling Green 5GW®2) | |
| Concentration of dyestuff | 0.038 % | | 0.56 % | |
| pH of dye bath | 3.3 | | 3.15 | |
| Temperature of dye bath | 90°C | | 92°C | |
| Time period for dyeing | 15 min | | 16 min | |
| Results | a glass base plate having a membrane dyed deep green was obtained | a glass base plate having a membrane only dyed to the extent of stains was obtained | a glass base plate having a membrane dyed deep green was obtained | a glass base plate having a membrane only dyed to the extent of stains was obtained |

Note: 1) and 2) made by Nippon Kayaku Co., Ltd.

Example 14

A solution prepared by mixing the reagents set forth below was subjected to polymerization under a nitrogen atmosphere at 80°C for 8 hours by a conventional method to obtain 100 parts of a solution of poly(N,N-dimethylamino)ethyl acrylate.

69.5 parts of toluene,
30 parts of (N,N-dimethylamino)ethyl acrylate and
0.5 part of α,α'-azobis(isobutyronitrile)

After adding 15 parts of 4-bromo-1-butene into 50 parts of the thus obtained solution of polymer, the mixture was reacted at ambient temperature and after 70 hours the whole mixture solidified.

By dissolving the thus obtained solidified material into 260 parts of 2-ethoxyethanol and further dissolving 14 parts of Irgacure® 651 into the thus prepared solution, a photoreactive resin composition was obtained.

Then, the thus obtained resin composition was spin-coated onto a glass plate in the same manner as in Example 6 to obtain a membrane 1 μm thick on the glass plate. The membrane was not so sticky and its processability was favorable.

The thus treated glass plate was irradiated with ultraviolet rays (80 W/cm) for 6 sec to cure the membrane thereon.

Thereafter, the thus treated glass plate was subjected to dyeing in a dye bath of an aqueous 0.048% solution (pH of 8.0) of "Green 1P" (a colouring matter for colour filters, made by Nippon Kayaku Co., Ltd.) at 60°C for 10 min in the same manner as in Example 6 to obtain a glass base plate having a transparent membrane dyed deep green thereon.

Reference Example 10

Into 50 parts of the same solution of poly(N,N-dimethylamino)ethyl acrylate in toluene as in Example 14, 260 parts of 2-ethoxyethanol and 14 parts of Irgacure® 651 were added to obtain a resin composition.

After spin-coating the thus obtained resin composition onto a glass plate, and irradiating the thus treated glass plate with ultraviolet rays under the same conditions as in Example 14, the thus treated glass plate was subjected to dyeing in the same manner as in Example 14 to obtain a glass base plate having a dyed membrane. However, the dyed membrane was opaque and partly exfoliated from the glass base plate. In short, the thus obtained glass base plate could not be put to practical use.

Example 15

Into 50 parts of the same solution of poly(N,N-dimethylamino)ethyl acrylate as in Example 14, 15 parts of allyl chloroacetate were added, and the mixture was subjected to reaction at room temperature. After 20 hours of the reaction, a solidified reaction mixture was obtained. The thus obtained solidified material was dissolved in 240 parts of 2-ethoxyethanol, and by further adding 12 parts of Irgacure® 651 to the thus prepared solution, a photoreactive resin composition was obtained.

By spin-coating the thus obtained resin composition onto a glass plate in the same manner as in Example 6, a glass plate having a non-sticky and favourably processable membrane 1 μm thick thereon was obtained. After irradiating the thus treated glass plate with ultraviolet rays (80 W/cm) for 6 sec, thereby curing the membrane, the thus treated glass plate was subjected to dyeing in the same manner as in Example 14 to obtain a glass base plate having a transparent membrane dyed deep green thereon.

Example 16

A solution prepared by mixing the reagents set forth below was subjected to polymerization under a nitrogen atmosphere at 80°C for 8 hours to obtain 300 parts of a solution of a copolymer of (N,N'-dimethylamino)ethyl acrylate and (N,N'-dimethylamino)ethyl methacrylate.

207 parts of toluene,
45 parts of (N,N-dimethylamino)ethyl acrylate,
45 parta of (N,N-dimethylamino)ethyl methacrylate and
3 parts of α,α'-azobis(isobutyronitrile).

After adding 25 parts of β-bromoethyl cinnamate into 50 parts of the thus obtained solution of copolymer, the mixture was subjected to reaction at room temperature and, after 5 days of reaction, a viscous reaction mixture was obtained.

A yellow precipitate formed by adding the viscous mixture into petroleum ether was collected by filtration and dried under a reduced pressure to obtain a dried, solid material.

Then, 20 parts of the thus obtained solid material and 2 parts of Michler's ketone were mixed with 80 parts of 2-ethoxyethanol to obtain a photoreactive resin composition.

After spin-coating the thus obtained resin composition onto a glass plate in the same manner as in Example 6 to form a non-sticky and favorably processable membrane of 1 μm thick thereon, the thus treated glass plate was irradiated with ultraviolet rays (80 W/cm) for 5 sec to cure the membrane thereon, and then subjected to dyeing under the same conditions as in Example 14. As a result, a glass base plate having a transparent membrane dyed deep green was obtained.

The process of the present invention and the product thereof are free from problems such as putrefactiveness and large variation of quality due to the raw material as compared with conventional

products and methods using a photosensitive resin made of a natural product such as gelatin and casein and treated by a bichromate salt. In addition, they are free from the environmental pollution problems of six valent chromium contained in the waste.

According to the present invention, it is possible to prepare coloured base materials having suitable properties by changing the monomeric ratio of the first vinyl monomer to the second vinyl monomer in copolymer (A).

In addition, since the membrane on the surface of the base material does not contain chromium, the base material having a dyed membrane thereon is suitable for use in a liquid crystal television set and as a colour filter of a solid photographing element.

Furthermore, since the membrane formed by curing the photoreactive resin composition (D) has excellent dyeability, it is possible to reduce the thickness of the membrane. Accordingly, it is possible to apply the base material onto a transparent electrode of a liquid crystal colour television set. The television picture is remarkably bright when using the base material produced by the process of the present invention as compared to using the conventional base material.

**Claims**

1. A process for producing a base material having a dyed membrane on a surface thereof, which process comprises applying a photoreactive resin composition (D) comprising (i) a copolymer (A) of a first vinyl monomer having photosensitive group(s) and a second vinyl monomer copolymerizable therewith and having group(s) having an affinity for an anionic dyestuff, (ii) optionally a photoreaction initiator (B) and (iii) a solvent (C), onto the surface of a base material thereby forming a membrane on the said surface; then irradiating the thus formed membrane with activating radiation to initiate a reaction in the said membrane; and dyeing the thus treated membrane with an anionic dyestuff, characterised in that the said first vinyl monomer is one or more compounds selected from p-cinnamoyloxystyrene, β-cinnamoyloxyethyl vinyl ether, β-cinnamoyloxyethyl acrylate, β-cinnamoyloxyethyl methacrylate, p-(cinnamoyloxymethyl)styrene, p-cinnamoylideneacetoxystyrene, β-(furfurylacryloyloxy)ethyl acrylate, β-(furfurylacryloyloxy)ethyl methacrylate, 7-acryloyloxycoumarine, 7-methacryloyloxycoumarine, 6-hydroxymethylcoumarine acrylate, 6-hydroxymethylcoumarine methacrylate, β-(p-cinnamoylphenoxy-ethyl)vinyl ether, p-(β-styrylphenyl)acrylate, p-(β-styrylphenyl)methacrylate, p-phenylmaleimidoacetoxy-styrene, 4'-methacryloyloxy-4-stilbazole and 1-methyl-4-(p-methacryloyloxystyrylpyridinium) methosulfate; and in that the second vinyl monomer is one or more compounds selected from (N,N-dimethylamino)ethyl acrylate, (N,N-dimethylamino)ethyl methacrylate, (N,N-dimethylamino)ethyl acrylate, (N,N-diethylamino)ethyl methacrylate, (N,N-diethylamino)propyl acrylate, (N,N-dimethylamino)propyl methacrylate, (N,N-dimethylamino)propyl acrylamide, (N,N-diethylamino)ethyl vinyl ether, 4-vinylpyridine, diallylamine, 2-hydroxy-3-methacryloyloxypropyltrimethylammonium chloride, methacryloyloxyethyltrimethylammonium chloride, methacryloyloxypropyltrimethylammonium chloride, acryloyloxyethyltrimethylammonium chloride and acryloyloxypropyltrimethylammonium chloride.

2. A process for producing a base material having a dyed membrane on a surface thereof, which process comprises applying a photoreactive resin composition (D) comprising (i) a copolymer (A) composed of first monomeric units having photosensitive group(s) and second monomeric units having group(s) having affinity for an anionic dyestuff, (ii) optionally a photoreaction initiator (B) and (iii) a solvent (C), onto the surface of a base material thereby forming a membrane on the said surface; then irradiating the thus formed membrane with activating radiation to initiate a reaction in the said membrane; and dyeing the thus treated membrane with an anionic dyestuff, characterised in that:

(1) the said copolymer (A) has been obtained by reacting a homo- or copolymer, obtained by polymerizing a vinyl monomer having tertiary amino group(s), with a compound having both active halogen atom(s) and carbon-carbon unsaturated bond(s),

(2) the said vinyl monomer having tertiary amino group(s) is one or more compounds selected from (N,N-dimethylamino)ethyl acrylate, (N,N-dimethylamino)ethyl methacrylate, (N,N-diethylamino)ethyl acrylate, (N,N-diethylamino)ethyl methacrylate, (N,N-dimethylamino)propyl acrylate, (N,N-dimethylamino)propyl methacrylate, (N,N-dimethylamino)propyl acrylamide, (N,N-diethylamino)ethyl vinyl ether, 4-vinylpyridine and diallylamine, and in that

(3) the said compound having both active halogen atom(s) and carbon-carbon unsaturated bond(s) is one or more compounds selected from allyl chloride, allyl bromide, 3-chloro-2-methylpropene, 3-chloro-1-methylpropene, 4-bromo-1-butene, allyl chloroacetate, vinyl chloroacetate, γ-chloroisobutene, m-chloromethylstyrene, p-chloromethylstyrene, crotyl bromide, 3-chloro-2-hydroxypropyl methacrylate, β-chloroethyl cinnamate, β-bromoethyl cinnamate, β-bromoethyl cinnamylideneacetate, β-bromoethyl furylacrylate, p-β-bromoethyloxycarbonylbenzalacetophenone and 4-chloroacetoxystilbene.

3. A process according to claim 1 or 2 wherein the said solvent (C) is selected from 2-methoxyethanol, 2-ethoxyethanol, toluene, xylene, ethylene glycol monoethyl ether acetate and N-methyl-2-pyrrolidone.

4. A process according to any one of the preceding claims wherein

(1) the proportion of units having photosensitive group(s) in the said copolymer (A) is from 0.2 to 30 mol%;

(2) the proportion of units having group(s) having an affinity for an anionic dyestuff in the said copolymer (A) is not less than 20 mol%;

(3) not more than 30 parts by weight of the said photoreaction initiator (B) are used per 100 parts by weight of the said copolymer (A); and

(4) the viscosity of the said photoreactive resin composition (D) is not more than 1 Pas (1000 cps).

5. A process according to any one of the preceding claims wherein the said photoreactive resin composition (D) further contains not more than 200% by weight of a compound having two or more of photosensitive groups per molecule.

6. A process according to claim 5, wherein the said compound having two or more of photosensitive groups is one or more compounds selected from ethylene glycol diacrylate, diethylene glycol diacrylate, triethylene glycol diacrylate, polyethylene glycol diacrylate, polyethylene glycol dimethacrylate, polypropylene glycol diacrylate, polypropylene glycol dimethacrylate, butylene glycol diacrylate, butylene glycol dimethacrylate, neopentyl glycol diacrylate, neopentyl glycol dimethacrylate, 1,4-butanediol diacrylate, 1,6-hexanediol diacrylate, 1,6-hexanediol dimethacrylate, pentaerythritol diacrylate, pentaerythritol triacrylate, trimethylolpropane triacrylate, trimethylolpropane trimethacrylate, novolak epoxyacrylates, bisphenol A epoxyacrylates, alkylene glycol diepoxyacrylates, glycidyl ester acrylate, polyester diacrylates, bisphenol A diacrylates and urethane diacrylates.

7. A process according to any one of the preceding claims wherein the said base material is glass or a synthetic resin.

8. A liquid crystal colour television set incorporating, as a colour filter, a base material having a dyed membrane on a surface thereof which has been produced by a process as claimed in claim 7.

**Patentansprüche**

1. Verfahren zur Herstellung eines Trägermaterials mit einer gefärbten Membran auf einer seiner Oberflächen, indem man eine photoreaktive Harzmasse (D), welche (i) ein Copolymer (A) aus einem ersten Vinylmonomer mit (einer) lichtempfindlichen Gruppe(n) und einem zweiten damit copolymerisierbaren Vinylmonomer mit (einer) Gruppe(n) mit Affinität zu einem anionischen Farbstoff, (ii) wahlweise einen Photoreaktionsinitiator (B) and (iii) ein Lösungsmittel (C) enthält, auf die Oberfläche eines Trägermaterials unter Bildung einer Membran auf dieser Oberfläche aufträgt, dann die in dieser Weise ausgebildete Membran mit aktivierender Strahlung zur Initiierung einer Reaktion in der Membran bestrahlt und die in dieser Weise behandelte Membran mit einem anionischen Farbstoff färbt, dadurch gekennzeichnet, daß das erste Vinylmonomer aus einer oder mehreren Verbindungen der Gruppe p-Cinnamoyloxystyrol, β-Cinnamoyloxyethylvinyl-ether, β-Cinnamoyloxyethylacrylat, β-Cinnamoyloxyethylmethacrylat, p-(Cinnamoyloxymethyl)styrol, p-Cinnamoylidenacetoxystyrol, β-(Furfurylacryloyloxy)ethylacrylat, β-(Furfurylacryloyloxy)ethylmethacrylat, 7-Acryloyloxycumarin, 7-Methacryloyloxycumarin, 6-Hydroxymethylcumarinacrylat, 6-Hydroxymethylcumarinmethacrylat, β-(p-Cinnamoylphenoxyethyl)-vinylether, p-(β-Styrylphenyl)acrylat, p-(β-Styrylphenyl)methacrylat, p-Phenylmaleimidoacetoxystyrol, 4'-Methacryloyloxy-4-stilbazol und 1-Methyl-4-(p-methacryl-oyloxystyrylpyridinium)methosulfat; und das zweite Vinylmonomer aus einer oder mehreren Verbindungen der Gruppe (N,N-Dimethylamino)-ethylacrylat, (N,N-Dimethylamino)ethylmethacrylat, (N,N-Diethylamino)ethylacrylat, (N,N-Dimethyl-amino)ethylmethacrylat, (N,N-Dimethylamino)propylacrylat, (N,N-Dimethylamino)propylmethacrylat, (N,N-Dimethylamino)propylacrylamid, (N,N-Dimethylamino)ethylvinyl ether, 4-Vinylpyridin, Diallylamin, 2-Hydroxy-3-methacryloyloxypropyltrimethylammoniumchlorid, Methacryloyloxyethyltrimethylammo-niumchlorid, Methacryloyloxypropyltrimethylammoniumchlorid, Acryloyloxyethyltrimethylammonium-chlorid und Acryloyloxypropyltrimethylammoniumchlorid gewählt sind.

2. Verfahren zur Herstellung eines Trägermaterials mit einer gefärbten Membran auf einer seiner Oberflächen, indem man eine photoreaktive Harzmasse (D), welche (i) ein Copolymer (A) aus ersten Monomereinheiten mit (einer) lichtempfindlichen Gruppe(n) und zweiten Monomereinheiten mit (einer) Gruppe(n) mit Affinität zu einem anionischen Farbstoff, (ii) wahlweise einen Photoreaktionsinitiator (B) und (iii) ein Lösungsmittel (C) enthält, auf die Oberfläche eines Trägermaterials unter Bildung einer Membran auf dieser Oberfläche aufträgt, dann die in dieser Weise ausgebildete Membran mit aktivierender Strahlung zur Initiierung einer Reaktion in dieser Membran bestrahlt und die in dieser Weise behandelte Membran mit einem anionischen Farbstoff färbt, dadurch gekennzeichnet, daß

(1) man das Copolymer (A) durch Umsetzung eines Mono- oder Copolymeren, welches man durch Polymerisieren eines Vinylmonomeren mit (einer) tertiären Aminogruppe(n) und einer Verbindung mit sowohl (einem) aktiven Halogenatom(en) als auch (einer) ungesättigten Kohlenstoff-Kohlenstoff-Bindung(en) erhält, erhält,

(2) das Vinylmonomer mit (einer) tertiären Aminogruppe(n) aus einer oder mehreren Verbindungen der Gruppe (N,N-Dimethylamino)ethylacrylat, (N,N-Dimethylamino)ethylmethacrylat, (N,N-Diethylamino)-ethylacrylat, (N,N-Diethylamino)ethylmethacrylat, (N,N-Dimethylamino)propylacrylat, (N,N-Dimethyl-amino)propylmethacrylat, (N,N-Dimethylamino)propylacrylamid, (N,N-Diethylamino)ethylvinylether, 4-Vinylpyridin und Diallylamin und

(3) die Verbindung mit sowohl (einem) aktiven Halogenatom(en) als auch (einer) ungesättigten Kohlenstoff-Kohlenstoff-Bindung(en) aus einer Verbindung oder Verbindungen der Gruppe Allylchlorid, Allylbromid, 3-Chlor-2-methylpropen, 3-Chlor-1-methylpropen, 4-Brom-1-buten, Allylchloroacetat, Vinylchlor-acetat, γ-Chlorisobuten, m-Chlormethylstyrol, p-Chlormethylstyrol, Crotylbromid, 3-Chlor-2-hydroxypropylmethacrylat, β-Chlorethylcinnamat, β-Bromethylcinnamat, β-Bromethylcinnamylidenacetat, β-Bromethylfurylacrylat, p-β-Bromethyloxycarbonylbenzalacetophenon und 4-Chloracetoxystilben gewählt sind.

3. Verfahren nach Anspruch 1 oder 2, worin das Lösungsmittel (C) aus der Gruppe 2-Methoxyethanol, 2-Ethoxyethanol, Toluol, Xylol, Ethylenglykolmonoethyletheracetat und N-Methyl-2-pyrrolidon gewählt ist.

4. Verfahren nach einem der vorangegangenen Ansprüche, worin

(1) das Verhältnis der Einheiten mit (einer) lichtempfindlichen Gruppe(n) im Copolymer (A) 0,2 bis 30 Mol-% beträgt;

(2) das Verhältnis der Einheiten mit (einer) Gruppe(n) mit Affinität zu einem anionischen Farbstoff im Copolymer (A) nicht weniger als 20 Mol-% beträgt;

(3) man nicht mehr als 30 Gew.-Teile des Photoreaktionsinitiators (B) pro 100 Gew.-Teile des Copolymeren (A) verwendet und

(4) die Viskosität der photoreaktiven Harzmasse (D) nicht weniger als 1 Pas (100 cps) beträgt.

5. Verfahren nach einem der vorangegangenen Ansprüche, worin die photoreaktive Harzmasse (D) weiterhin nicht mehr als 200 Gew.-% einer Verbindung mit zwei oder mehr lichtempfindlichen Gruppen pro Molekül enthält.

6. Verfahren nach Anspruch 5, worin die Verbindung mit zwei oder mehr lichtempfindlichen Gruppen aus einer oder mehreren Verbindungen der Gruppe Ethylenglykoldiacrylat, Diethylenglykoldiacrylat, Triethylenglykoldiacrylat, Polyethylenglykoldiacrylat, Polyethylenglykoldimethacrylat, Polypropylenglykoldiacrylat, Polypropylenglykoldimethacrylat, Butylenglykoldiacrylat, Butylenglykoldimethacrylat, Neopentylglykoldiacrylat, Neopentylglykoldimethacrylat, 1,4-Butandioldiacrylat, 1,6-Hexandioldiacrylat, 1,6-Hexandioldimethacrylat, Pentaerythritdiacrylat, Pentaerythrittriacrylat, Trimethylolpropantriacrylat, Trimethylolpropantrimethacrylat, Novolak-Epoxyacrylate, Bisphenol A-Epoxyacrylat, Alkylenglykoldiepoxyacrylat, Glycidylesteracrylat, Polyesterdiacrylate, Bisphenol A-Diacrylate und Urethandiacrylate gewählt ist.

7. Verfahren nach einem der vorangegangenen Ansprüche, worin das Trägermaterial aus Glas oder einem synthetischen Harz besteht.

8. Flüssigkeitskristall-Farbfernsehgeräteinheit mit einem Trägermaterial mit einer gefärbten Membran auf einer seiner Oberflächen als Farbfilter, welches nach einem Verfahren nach Anspruch 7 hergestellt worden ist.

**Revendications**

1. Procédé pour la production d'un matériau de base dont une surface porte une membrane colorée, lequel procédé comprend l'application d'une composition de résine photoréactive (D) comprenant (i) un copolymère (A) d'un premier monomère vinylique comportant un ou plusieurs groupes photosensibles et un second monomère vinylique copolymérisable avec celui-ci et comportant un ou plusieurs groupes ayant de l'affinité pour un colorant anionique, (ii) facultativement, un initiateur de photoréaction (B) et (iii) un solvant (C), sur la surface d'un matériau de base pour former ainsi une membrane sur ladite surface; puis l'irradiation de la membrane ainsi formée avec un rayonnement activateur pour amorcer une réaction dans ladite membrane; et la coloration de la membrane ainsi traitée avec un colorant anionique, caractérisé en ce que ledit premier monomère vinylique consiste en un ou plusieurs composés choisis parmi le p-cinnamoyloxystyrène, l'éther de β-cinnamoyloxyéthyle et de vinyle, l'acrylate de β-cinnamoyloxyéthyle, le méthacrylate de β-cinnamoyloxyéthyle, le p-(cinnamoyloxyméthyl)styrène, le p-cinnamoylidèneacétoxystyrène, l'acrylate de β-(furfurylacryloyloxy)éthyle, le méthacrylate de β-(furfurylacryloyloxy)éthyle, la 7-acroyloxycoumarine, la 7-méthacroyloxycoumarine, l'acrylate de 6-hydroxyméthylcoumarine, le méthacrylate de 6-hydroxyméthylcoumarine, l'éther de β-(p-cinnamoylphénoxyéthyle) et de vinyle, l'acrylate de p(β-styrylphényle), le méthacrylate de p-(β-styrylphényle), le p-phénylmaléimidoacétoxystyrène, le 4'-méthacroyloxy-4-stilbazone et le méthosulfate de 1-méthyl-4-(p-méthacroyloxystyrylpyridinium); et en ce que le second monomère vinylique consiste en un ou plusieurs composés choisis parmi l'acrylate de (N,N-diméthylamino)éthyle, le méthacylate de (N,N-diméthylamino)éthyle, l'acrylate de (N,N-diméthylamino)éthyle, le méthacrylate de (N,N-diéthylamino)éthyle, l'acrylate de (N,N-diéthylamino)propyle, le méthacrylate de (N,N-diméthylamino)propyle, le (N,N-diméthylamino)propylacrylamide, l'éther de (N,N-diéthylamino)éthyle et de vinyle, la 4-vinylpyridine, la diallylamine, le chlorure de 2-hydroxy-3-méthacroyloxypropyltriméthylammonium, le chlorure de méthacroyloxyéthyltriméthylammonium, le chlorure de méthacroyloxypropyltriméthylammonium, le chlorure d'acroyloxyéthyltriméthylammonium et le chlorure d'acroyloxypropyltriméthylammonium.

2. Procédé pour la production d'un matériau de base dont une surface porte une membrane colorée, lequel procédé comprend l'application d'une composition de résine photoréactive (D) comprenant (i) un copolymère (A) composé de premiers motifs monomères comportant un ou plusieurs groupes photosensibles et de seconds motifs monomères comportant un ou plusieurs groupes ayant de l'affinité pour un colorant anionique, (ii) facultativement, un initiateur de photoréaction (B) et (iii) un solvant (C), sur la surface d'un matériau de base pour former ainsi une membrane sur ladite surface; puis l'irradiation de la membrane ainsi formée avec un rayonnement activateur pour amorcer une réaction dans ladite membrane; et la coloration de la membrane ainsi traitée avec un colorant anionique, caractérisé en ce que:

(1) ledit copolymère (A) a été obtenu en faisant réagir un homo- ou copolymère, obtenu par polymérisation d'un monomère vinylique comportant un ou plusieurs groupes amino tertiaires, avec un composé comportant à la fois un ou plusieurs atomes d'halogène actif et une ou plusieurs liaisons insaturées carbone-carbone,

(2) ledit monomère vinylique comportant un ou plusieurs groupes amino tertiaires consiste en un ou plusieurs composés choisis parmi l'acrylate de (N,N-diméthylamino)éthyle, le méthacrylate de (N,N-diméthylamino)éthyle, l'acrylate de (N,N-diéthylamino)éthyle, le méthacrylate de (N,N-diéthylamino)éthyle, l'acrylate de (N,N-diméthylamino)propyle, le méthacrylate de (N,N-diméthylamino)propyle, le (N,N-diméthylamino)propylacrylamide, l'éther de (N,N-diéthylamino)éthyle et de vinyle, la 4-vinylpyridine et la diallylamine, et en ce que

(3) ledit composé comportant à la fois un ou plusieurs atomes d'halogène actif et une ou plusieurs liaisons insaturées carbone-carbone consiste en un ou plusieurs composés choisis parmi le chlorure d'allyle, le bromure d'allyle, le 3-chloro-2-méthylpropène, le 3-chloro-1-méthylpropène, le 4-bromo-1-butène, le chloracétate d'allyle, le chloracétate de vinyle, le γ-chloroisobutène, le m-chlorométhylstyrène, le p-chlorométhylstyrène, le bromure de crotyle, le méthacrylate de 3-chloro-2-hydroxypropyle, le cinnamate de β-chloréthyle, le cinnamate de β-bromoéthyle, le cinnamylidène-acétate de β-bromoéthyle, le furylacrylate de β-bromoéthyle, la p-β-bromoéthyloxycarbonylbenzalacétophénone et le 4-chloroacétoxystilbène.

3. Procédé selon la revendication 1 ou 2, dans lequel ledit solvant (C) est choisi parmi le 2-méthoxyéthanol, le 2-éthoxyéthanol, le toluène, le xylène, l'acétate d'éther monoéthylique de l'éthylène-glycol et la N-méthyl-2-pyrrolidone.

4. Procédé selon l'une quelconque des revendications précédentes, dans lequel

(1) la proportion de motifs comportant un ou plusieurs groupes photosensibles dans ledit copolymère (A) est de 0,2 à 30 moles %;

(2) la proportion de motifs comportant un ou plusieurs groupes ayant de l'affinité pour un colorant anionique dans ledit copolymère (A) n'est pas inférieure à 20 moles %;

(3) il n'est pas utilisé plus de 30 parties en poids dudit initiateur de photoréaction (B) pour 100 parties en poids dudit copolymère (A); et

(4) la viscosité de ladite composition de résine photoréactive (D) n'est pas supérieure à 1 Pa.s (1000 cPo).

5. Procédé selon l'une quelconque des revendications précédentes, dans lequel ladite composition de résine photoréactive (D) ne contient en outre pas plus de 200% en poids d'un composé comportant deux ou plusieurs groupes photosensibles par molécule.

6. Procédé selon la revendication 5, dans lequel ledit composé comportant deux ou plusieurs groupes photosensibles consiste en un ou plusieurs composés choisis parmi le diacrylate d'éthylène-glycol, le diacrylate d'éthylène-glycol, le diacrylate de diéthylène-glycol, le diacrylate de triéthylène-glycol, un diacrylate de polyéthylène-glycol, un diméthacrylate de polyéthylène-glycol, un diacrylate de polypropylène-glycol, un diméthacrylate de polypropylène-glycol, le diacrylate de butylène-glycol, le diméthacrylate de butylène-glycol, le diacrylate de néopentyl-glycol, le diméthacrylate de néopentyl-glycol, le diacrylate de 1,4-butanediol, le diacrylate de 1,6-hexanediol, le diméthacrylate de 1,6-hexanediol, le diacrylate de pentaérythritol, le triacrylate de pentaérythritol, le triacrylate de triméthylolpropane, le triméthacrylate de triméthylolpropane, les époxyacrylates de novolaques, les époxyacrylates de bisphénol-A, les diépoxyacrylates d'alkylène-glycols, un acrylate d'ester de glycidyle, les diacrylates de polyesters, les diacrylates de bisphénol-A et les diacrylates d'uréthanne.

7. Procédé selon l'une quelconque des revendications précédentes, dans lequel ledit matériau de base est du verre ou une résine synthétique.

8. Récepteur de télévision en couleurs à cristaux liquides comprenant, comme filtre coloré, un matériau de base dont une surface porte une membrane colorée, qui a été produit par un procédé tel que revendiqué dans la revendication 7.